(19) Europäisches Patentamt
European Patent Office
Office européen des brevets

(11) **EP 2 508 898 A1**

(12) **EUROPEAN PATENT APPLICATION**

(43) Date of publication:
**10.10.2012 Bulletin 2012/41**

(51) Int Cl.:
***G01R 15/06*** (2006.01)

(21) Application number: **11161709.8**

(22) Date of filing: **08.04.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Eandis**
 **9090 Melle (BE)**
• **Katholieke Universiteit Leuven, K.U. Leuven R&D**
 **3000 Leuven (BE)**

(72) Inventors:
• **De Rybel, Tom**
 **9320 Nieuwerkerken (BE)**
• **Vandewinckel, Eric**
 **3110 Rotselaar (BE)**

(74) Representative: **Mackett, Margaret Dawn et al**
 **Gevers**
 **Holidaystraat 5**
 **1831 Diegem (BE)**

(54) **Guarding methods for high voltage measurements**

(57) Described herein is a method and apparatus for measuring the potential on a modern shielded high-voltage cable such as those used in medium-voltage distribution networks. A capacitive sensor arrangement (100) is constructed on a cable (110) using pre-existing structures (114, 116, 118) within the cable (110). An electrode element (152) and first and second guard electrodes (154, 156) are formed on a semiconducting layer (120) that may comprise a non-linear resistive material that is applied to portion of the cable (110) where the semiconductor layer (118) has been removed or is not present. The first and second guard electrodes (154, 156) are at the same potential as the electrode element (152) to minimise the effects of undesired and time-variant resistive elements due to contamination and/or the environment and the conductivity of the semiconducting layer itself, if present. Performance of the sensor arrangement (100) can also be improved using temperature compensation techniques.

*F i g . 1*

EP 2 508 898 A1

## Description

The present invention relates to guarding methods for high voltage measurements, and is more particularly concerned with guarding methods for field or capacitance-based high voltage measurements.

In general, there are four main methods of measuring alternating voltages in high and medium voltage transmission and distribution systems, namely: magnetic methods in which potential transformers, for example, are used; methods utilising a potential divider or tap using impedances; optical methods utilising Pockels cells and liquid crystals etc; and mechanical methods utilising field mills, vibrating reeds etc. In addition, such methods can be combined to provide further methods of measuring high and medium alternating voltages.

Voltage measurements in high-voltage systems are traditionally made using potential transformers or capacitively-coupled potential transformers. These devices are both large and expensive, precluding their wide-spread use in many applications. In addition, as both these types of transformers require a direct connection to the high-voltage conductor, extensive safety precautions need to be put into place to ensure the necessary isolation requirements are provided.

Voltage dividers, either resistive or capacitive, are a second class of devices used when less measurement precision is acceptable. Resistive voltage dividers have the disadvantage that a galvanic connection to the high-voltage conductor is required. Capacitive voltage dividers can, however, be implemented so that the required isolation to the high-voltage is already provided by the existing installation.

Capacitive methods for measuring the potential on high-voltage cables are known.

In DE-A-3702735, a method is described for constructing a capacitive element and a capacitive voltage divider on a cable so that the line voltage at any location along a cable system can be measured. In this method, the dielectric strength of a high-voltage capacitor is determined by conductor insulation of the cable itself, and, the voltage divider can subsequently be installed by applying specially shaped connecting sleeves or cable terminations at any point in a cable network to allow continuous voltage measurement at any number of test points in a cable network.

This method, however, has the disadvantage that the electric field within the cable may be perturbed by the added structures and its service life compromised due to the absence of semiconducting layers present in modern state of the art medium voltage cables. [By the term "semiconducting layer" is meant, as is well known in the art, a resistive material, typically, a carbon-laden polymer. In some cases, it may be a non-linear material whose resistivity decreases with increasing voltage.] Modern high-voltage cables use such layers to prevent electric field discontinuities in the cable and thus improve reliability and enable a thinner dielectric to be used. Furthermore, the method is based on a full capacitive divider, and therefore provides a voltage based output. Such methods are extremely sensitive to moisture contamination, or any other effect that adds, even very small amounts, of conductivity to the sensor structures. This means that, even slight contamination, results in significant errors in any measurements taken. This makes the integrity of mechanical construction critical to maintain stability over the life of the device.

Known capacitive voltage measurement methods fail in practice due to two factors. On one hand, voltage-based methods are highly susceptible to contamination, and on the other, modern cables use thin dielectrics and rely on field gradient control to keep the internal electric fields free from discontinuities and prevent breakdown of the dielectric.

It is therefore an object of the present invention to provide a high voltage measurement system in which guard electrodes are used on an electrical cable on which measurements are to be made. In particular, the high voltage measurement system is compatible with field control measures used on the electrical cable and which include the use of a semi-conducting layer.

In accordance with one aspect of the present invention, there is provided measurement apparatus for measuring the voltage of an insulated electrical cable including at least one central conductor and at least a dielectric layer formed over the central conductor(s), the apparatus comprising:- an electrode element arranged around the cable; and an electrical circuit connected to the electrode element and said at least one central conductor; characterised in that the electrode element and the insulated electrical cable together form a sensing capacitor that is connected to the electrical circuit, the sensing capacitor has a dielectric that comprises at least the dielectric layer and the semiconducting layer of the insulated electrical cable; and in that the measurement apparatus further comprises first and second guard electrode elements arranged on either side of the electrode element and spaced to be equi-distant from therefrom.

In one embodiment of the present invention, the semiconducting layer may be present within the cable construction. In another embodiment, the semiconducting layer may need to be added. In a further embodiment, the semiconducting layer may not be necessary.

It is preferred that the guard electrode elements are equi-distant from the electrode element, but this is not essential.

The addition of these guard electrode elements negates the contamination effects to a large extent. In addition, the use of the pre-existing semiconducting layer in state of the art medium voltage cables ensures that the electric field within the cable is not perturbed by the added structures.

When guarding is used, the practical issues associated with sensor contamination and other undesired parasitic components are effectively resolved. In addition, due to guarding, the sensor can, with some restrictions, be built on top of the semiconducting layer. The semiconducting layer is a good conductor compared with the impedance of the constructed coupling capacitance for power frequencies, and thus still yields an accurate result.

The present invention is based on a capacitive coupling using the existing structure of a high or medium voltage cable as a significant portion of the coupling capacitor of the sensor unit that is used for measurement of the voltage on the insulated electrical cable. Due to the use of capacitive coupling, no galvanic contact is required with the electrical conductor. In accordance with the present invention, the cable construction is used to advantage, especially with regards to the intrinsic dimensional and mechanical stability of a given section of cable and its associated elements.

In the measurement apparatus of the present invention, the high-voltage cable itself is utilised as part of the measurement apparatus as it already provides the conductor and associated isolation. The sensor, in the form of an electrode element, is built on top of these pre-existing structures and therefore does not require an additional high-voltage isolating body. As such, no additional high-voltage connections nered be made to a separate unit incorporating the sensor, nor is there a need to interact with the high-voltage conductor itself.

In contrast to some prior art measurement apparatus, the measurement apparatus of the present invention may form a fixed construction on the cable and therefore overcomes any problems associated with mechanical stability of temporary connections made to enable the voltage measurement to be obtained. However, it will be appreciated that the measurement apparatus may be added to the cable when required for obtaining measurements and removed when no longer required.

It is preferred that the first and second guard electrode elements are electrically connected to one another and are at the same potential. It is also preferred that the first and second guard electrode elements are as close as possible to being at the same potential as the electrode element.

In one embodiment, the electrode elements are constructed directly on the dielectric layer.

The electrical cable may include a semiconducting layer formed over the dielectric layer, and wherein the electrode elements are constructed on the semiconducting layer. In one embodiment, the semiconducting layer has grooves formed through to the underlying dielectric layer between the electrode element and respective ones of the first and second guard electrode elements. In another embodiment, these grooves may be filled with another field-controlling material which may be a non-linear resistive material or another semiconducting material. The material used to fill the grooves should have suitable properties to reduce the small electric field perturbations caused by the grooves in the semiconducting layer. In further embodiment, the semiconducting layer comprises a non-linear resistive material.

Furthermore, in some embodiments, depending on the precise details of the chosen materials, the guard electrode elements better define the capacitor geometry provided by the electrode element so that the electrical dimension, due to the presence of the semiconducting layer, extends to the mid-point between the edge of the electrode element and the edge of the guard electrodes. This assumes that the semiconducting layer has a homogeneous and relatively low resistivity.

A further dielectric layer is preferably placed over at least the electrode element as well as the guard electrodes. The dielectric layer should preferably extend some distance beyond the guard electrodes. In addition, an electrostatic shield is preferably placed over the dielectric layer.

In one embodiment, the electrostatic shield is connected to a shield on the insulated electrical cable. This provides grounding of the electrostatic shield.

In another embodiment, the electrostatic shield comprises a shield on the insulated electrical cable and which extends over the electrical cable and the dielectric layer covering at least the electrode element.

The electrostatic shield may also serve to assist in the control of field gradients within the sensor construction. This is particularly the case where grooves are cut into the semiconducting layer or no semiconducting layer is present.

Advantageously, first and second additional electrode elements are positioned either side of the guard electrode elements, each additional electrode element being located adjacent a respective one of the first and second guard electrode elements and on a side remote from the electrode element.

This additional pair of electrode elements provides a better electrical contact surface, in certain cases, between the electrostatic shield and the semiconducting layer if present.

In this embodiment, the electrical circuit comprises a voltage-mode signal conditioning circuit.

For temperature compensation, a measurement capacitor associated with the electrode element may be utilised for voltage-mode operation. The measurement capacitor may be integrated with the electrode element to provide close thermal contact. In addition, a temperature sensor associated with the electrode element may be used alone or in conjunction with the measurement capacitor.

Advantageously, connections to the electrode elements of the measurement apparatus of the present invention may be made by a multi-axial conductor.

For a better understanding of the present invention, reference will now be made, by way of example only, to the accompanying drawings in which:-

Figure 1 is a schematic sectioned illustration of a first embodiment of a sensor in accordance with the present invention;

Figure 2 is a schematic sectioned illustration of a second embodiment of a sensor in accordance with the present invention;

Figure 3 is a schematic sectioned illustration of a third embodiment of a sensor in accordance with the present invention;

Figure 4 is a schematic illustration of the second sensor electrode configuration;

Figure 5 is a circuit diagram corresponding to the sensor electrode configuration of Figure 4;

Figure 6 is a simplified circuit diagram of a sensor when a voltage-mode conditioning unit incorporating a guard driver is used;

Figure 7 is a schematic illustration of a voltage-mode signal conditioning unit incorporating a guard driver;

Figure 8 is a schematic illustration of temperature compensation for voltage-mode operation;

Figure 9 is a circuit diagram of a first sensor simulation model;

Figure 10 is a graph illustrating simulated frequency response for the sensor simulation model of Figure 9;

Figure 11 is a circuit diagram of a second sensor simulation model;

Figure 12 is a graph illustrating simulated frequency response for the sensor simulation model of Figure 11;

Figure 13 is a circuit diagram of a third sensor simulation model;

Figure 14 is a graph illustrating simulated frequency response for the sensor simulation model of Figure 13;

Figure 15 is a circuit diagram of a sensor voltage-mode simulation model;

Figure 16 is a graph illustrating simulated frequency response for the sensor simulation model of Figure 15; and

Figure 17 is a circuit diagram of a signal conditioning circuit for voltage-mode operation incorporating a guard driver circuit.

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

The sensing device in accordance with the present invention uses pre-existing cable structures present in many modern high-voltage cables to implement the first part of a coupling capacitor to the high-voltage conductor. The cable conductor forms the first capacitor plate, the cable dielectric forms the capacitor dielectric, and a sensor electrode mechanically applied to the dielectric forms the second capacitor plate. An electrical connection is made to this second capacitor plate. By using the existing cable dielectric, the expensive and safety critical part of such an assembly, namely, the high-voltage isolation, is automatically provided.

In one embodiment of the present invention, the sensor is constructed over the semiconducting layer of the cable. In this embodiment, isolation may need to be provided between the electrodes forming the sensor, if the conductivity of the layer is very high. In case such isolation is required, the semiconducting layer may be removed locally so that the portion removed remains uncovered or is filled with a suitable non-linear field grading material of lower conductivity than the original semiconducting layer.

In another embodiment of the present invention, the sensor is constructed over the semiconducting layer of the cable, but in this case, the semiconducting layer comprises a non-linear resistive material with a relatively low conductivity during nominal operating conditions of the electrical cable.

In a further embodiment of the present invention, the semiconducting layer is removed, if present, before the sensor is constructed on the dielectric layer of the cable.

In all the embodiments mentioned above, a further dielectric layer or other protective layer is applied over the sensor after its construction. In addition, an electrostatic shield may be provided over the dielectric layer to prevent environmental influences, such as, proximity effects and electrical interference due to other equipment and current-carrying conductor in the vicinity from degrading the measurement. Preferably, the electrostatic shield comprises a metallic conductor which is attached to the cable on either side of the capacitor section. The electrostatic shield can also be connected to the cable shield which is grounded. The shield attachment should be spaced some distance from the edges of the guard electrodes to prevent shorting of the shield to the guard electrodes in the case where a semiconducting layer is present. Alternatively, the cable shield can be used in the same manner as the electrostatic shield.

In another embodiment, the electrostatic shield may form a second capacitor where the first plate comprises the constructed sensing capacitor electrode, and the second plate comprises the grounded electrostatic shield. The dielectric, in this embodiment, comprises the applied dielectric layer. It is be noted that this capacitor is in parallel with the impedance of those sections of material which run from the attachment points of the electrostatic shield to the sensing capacitor structures. Practically, in most cases, it may be necessary to connect this second capacitor in parallel with another capacitor having a different capacitance to obtain a desired voltage division ratio, if a voltage-type output is desired. Since this second capacitor is highly dependent on many construction variables and parasitic elements, the second capacitor will, in many practical cases, be large compared to the constructed capacitor in order to dominate the combined behaviour and achieve a more precise output.

In the construction of the sensor, the points where the electrostatic shield attaches to the semiconducting layer may be enhanced by applying a metallic conductor at those specific points. The applicability of this measure will depend on the types of material and techniques used in the construction. An additional pair of electrodes is attached, spaced between the capacitive sensing element and the points where the electrostatic shield attaches to the semiconducting layer. These electrodes are to be used as "guard" to compensate for the low impedance of the semiconducting layer and other factors that alter the performance of the sensor, such as, contamination of the structure. These "guard" structures ensure that sensor performance is maintained even with aging and the intrusion of contamination.

In those cases where a relatively high conductivity semiconducting layer is used and no grooves are made or required to segment the semiconducting layer into section, the effective capacitor size is defined by the metallic portion of the capacitor section and half the distance, at both sides, between this metallic portion and the edges of the metallic sections or the guard connection to the semiconductor layer. Here, the use of these metallic sections for the guard and sensor electrodes helps to define more precisely the active sensor geometry.

As the sensor may be constructed on top of the semiconducting layer of the cable in one embodiment of the present invention, the electric field inside the cable is virtually unaffected. In this embodiment, the semiconductor layer is undamaged on the side facing the high-voltage conductor if the semiconducting layer comprises a non-linear resistive material of sufficiently low conductance during normal operating conditions. This enables the guarding mechanism to maintain the desired accuracy. This, together with the continuity of the cable shield over the structure due to the electrostatic shield in the sensor, effectively ensures that there is no impact on the functionality of the cable itself. This is an important as discontinuities in the structures surrounding the cable dielectric may cause strong localised electric fields which may degrade the dielectric and cause damage and flashover, over time.

In the case where the semiconducting layer has too high a conductivity, it must be removed locally, in the form of grooves, for example, to reduce the conductivity between the sensor electrode and the guard electrodes. This is because too high a conductivity requires excessive precision from the guard circuitry which is not practical. These grooves may be filled with a different, lower conductivity non-linear material to maintain the field distribution in the cable. This is possible because the whole sensor assembly remains generally at a low potential compared to that of the cable shield so that limited fields are present in the groove regions. Furthermore, the remaining semiconducting layer will assist in field grading which will be significantly enhanced by the optional sections of lower conductivity material that is used to fill the gaps. The remaining sections of the semiconducting layer willgrade the field of the sharp-edged metallic electrode sections, generally avoiding the need for further field control measures.

Another benefit of the sensor construction in this embodiment is that pre-existing cable structures are used extensively for the construction of the most critical coupling capacitor elements of the sensor arrangement. These structures are moulded around the conductor and one another, resulting in a mechanically stable and resilient whole. By not tampering with this whole, the critical spacing between the capacitor plates of the sensing capacitor is well controlled and mechanically stable. Furthermore, this greatly reduces installation time of the sensor and also chance for error and degradation over time due to loosening adhesives, environmental contamination, or improper installation. The latter, especially, may cause issues due to electric field gradients and potential resulting dielectric degradation.

The result of the construction is a well-defined, small-value coupling capacitor to the high-voltage conductor. This capacitor may now be used in conjunction with a wide variety of circuits to obtain a measurement of the potential on the high-voltage conductor. The impedance of the semiconducting layer and the second capacitor, between the electrostatic or cable shield and the added electrode that comprises part of the coupling capacitor, are not well defined and care is needed to ensure they remain constant over time. However, these parasitic components offer some advantage as they divert transient effects and static build-ups.

For a voltage-based method, these adverse effects may be significantly reduced through the use of "guard" electrodes and placing a further capacitor of larger value and known, and advantageously chosen, properties in parallel with the second capacitor. The further capacitor will swamp out variations in the second capacitor.

Temperature correction techniques may also be added, either through direct measurement of the sensor temperature and correcting in the signal conditioning, or adding a temperature-dependent element that corrects the deviation in the signal conditioning. One implementation of the latter approach may be accomplished by integrating the required voltage division capacitor in the sensor so it is thermally joined with the sensor. By choosing a suitable type or combination of types, thermal dependence can be chosen to compensate for the thermally-induced changes in the coupling capacitance. The suitability of this will depend on the signal conditioning used and desired voltage division ratio. Both methods can be used separately or in conjunction with one another, depending on the desired required performance.

In the description below, the term "co-axial" refers to a cable where a continuous shield is present co-axially with a conductor, the shield and the conductor being separated by an isolator. Similarly, the term "tri-axial" refers to a cable that contains two co-axial shields around a central co-axial conductor, the shields and the conductor being electrically isolated. In one specific use of a tri-axial cable when connected to a guard electrode, the inner shield may be connected to a guard driver, the central conductor carries a signal and the outer shield is grounded.

As is known to those skilled in the art, the term "guarding" refers to a method where a signal conductor is surrounded by another conductor, the guard or guard electrode, which is kept at exactly the same potential as the signal conductor so that there is no net potential between the signal conductor and the guard with any current flow. This method is used to inhibit any parasitic impedance between the signal and the surrounding environment.

As mentioned above, the term "semiconducting layer" refers to a resistive material, typically, a carbon-laden polymer. It may also refer to a non-linear material whose resistivity decreases with increased applied voltage. Modern high-voltage cables use such layers to prevent electric field discontinuities in the cable. This improves reliability and a thinner dielectric layer can be used.

In the detailed description of the drawings that follows, elements that are the same in each of the Figures are reference the same.

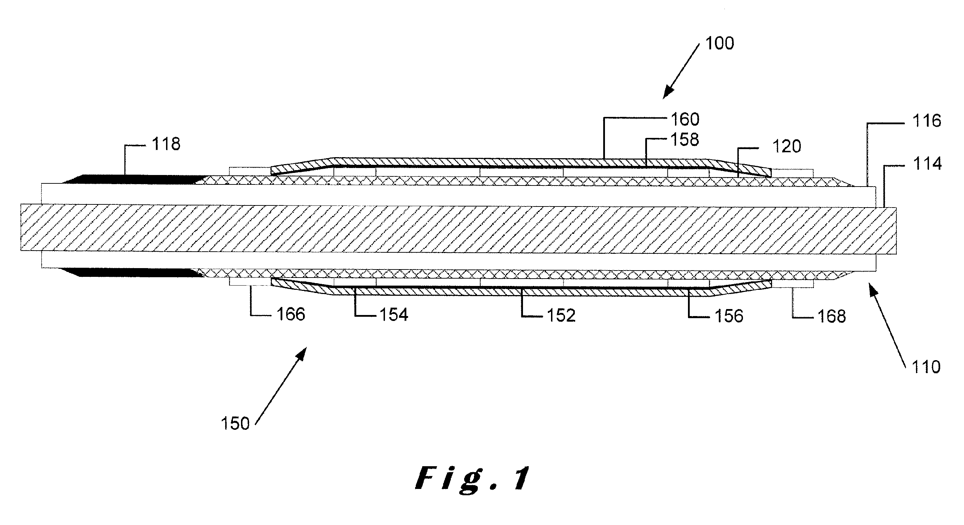

The present invention relates to constructing a coupling capacitor on a medium- or high-voltage cable. When constructing such a coupling capacitor, a short length of the cable can be used. For example, a length in the range of 1cm to 5cm could be used due to space constraints. The constructed capacitor is effectively a co-axial capacitor where the central conductor of the cable forms an inner cylinder and an added electrode forms an outer cylinder. The dielectric of the constructed capacitor is formed by components of the cable between the two cylinders. In practical cables, the dielectric has a relative permittivity of between 2 and 3 and with a spacing between the cylinders of between 0.5cm and 1cm, a coupling capacitor having a capacitance between 5pF and 20pF can be provided. Typically, a capacitance of around 15pF can be obtained for cross-linked polyethylene cables that are rated up to 15kV. However, regardless of the precise value of this capacitance, it is very small compared with the parasitic effects encountered when constructing the sensor for use with a grid fundamental of 50Hz and the underlying issue can be reduced to that of relative impedances, that is, the impedance of the coupling capacitor at 50Hz relative to the impedance of parasitic elements in the construction. An example of a constructed coupling capacitor is shown in Figure 1.

The impedance at 50Hz for a capacitance of 15pF can be determined using the formula:

$$Z = \frac{1}{j\omega C_{coupling}}$$

Here, Z is the impedance, w is the frequency and $C_{coupling}$ is the capacitance. For the values given above, Z is 212MΩ. This is an extremely high impedance compared to contamination effects such as, finger prints on the dielectric, small amounts of moisture and air humidity, imperfections in the sensor construction and its dielectrics, parasitic capacitances due to wiring and from the electrode to the cable shield etc.

It will be appreciated that the issue is not that the parasitic impedances are present, as they can be corrected in signal conditioning, but that many are both unknown and time variant. This means that if a circuit were to be calibrated for the parasitic impedances, the calibration would not remain accurate over time.

It must be noted that the majority of these parasitic impedances are located between the applied electrode and ground. The only parasitic of practical importance between the applied electrode and the cable centre conductor is the conductivity of the dielectric. This is typically in the order of hundreds to thousands of GΩ, for modern polymer dielectrics such as cross-linked polyethylene, and thus easily three orders of magnitude larger then the impedance of the coupling capacitance for the grid fundamental. Modern materials also have extremely low to practically non-existent moisture absorption that degrade their insulating properties. The dielectric conductivity can thus be ignored in most practical situations.

The thermal stability of the constructed coupling capacitor needs to be such that it follows faithfully the thermally-induced changes in geometry of the capacitor so that thermal correction can be used in the signal processing. This can take the form of suitably chosen components in the signal processing circuit that, when thermally coupled with the sensor environment, compensate for deviations. Alternatively, the temperature of the system can be monitored and used for corrections. The influence of thermally-induced geometry changes on the sensor is relatively small and they can be estimated using the following assumptions: the geometry change is mainly induced by the major structures, the cable centre conductor (taken to be aluminium); the dielectric (taken to be cross-linked polyethylene (XLPE)); and the coupling capacitor electrode (taken to be copper). The expansions of interest are those radial and axial to the cable length. Their combined influence on the coupling capacitor can be expressed as a function of ambient temperature. Typical values of linear expansion coefficients for the materials used at 25°C are: for elemental aluminium, 23.1μm m$^{-1}$K$^{-1}$; for elemental copper, 16.51μm m$^{-1}$ K$^{-1}$; and for XLPE, 2001μm m$^{-1}$ K$^{-1}$.

The equation that governs the capacitance of a co-axial capacitor structure is given by:

$$C = \frac{2\pi\varepsilon_0\varepsilon_r}{\ln\left(\dfrac{B}{A}\right)} L$$

Here, L is the length of the structure in metres, A the outer diameter of the centre conductor in metres, B the inner diameter of the outer electrode in metres, and $\epsilon_r$ the relative permittivity of the dielectric. For cross-linked polyethylene, $\epsilon_r=2.2$ and $\epsilon_0=8.8542\times10^{-12}Fm^{-1}$, the permittivity of vacuum.

A simple approximate expression for the temperature dependency of the coupling capacitance assuming the material properties remain constant over this temperature range. The first is the axial component, given by L above. Here, the only part that must be investigated is the axial length of the copper cylinder that is applied to the cable, as the cable passing through it may be considered to be infinitely long:-

$$L_{\Delta t} = L(\sigma_s \Delta t + 1)$$

Here, L is the length of the sensor element, $\Delta t$ is the change in temperature in degrees, and $\sigma_s$ is the thermal expansion coefficient in $m\ m^{-1}K^{-1}$ of the sensor element. The result is $L_{\Delta t}$, the effective length of the element in metres with the temperature effects included.

Over a $\pm25°C$ temperature variation, typical for a distribution sub-station where a range of 50°C around the temperature average is expected, and a copper sensor element of length 5cm, a change in axial length (and thus capacitance) of 0.04% is obtained.

The second part of the derivation is the radial component, given by the ratio of A and B. A the outer diameter of the centre conductor in metres, B the inner diameter of the outer electrode in metres. $\Delta t$ is the change in temperature in degrees, and $\sigma_c$ and $\sigma_d$ are the thermal expansion coefficient in $m\ m^{-1}K^{-1}$ of the centre conductor and dielectric respectively. The resulting new ratio,

$$\left(\frac{B}{A}\right)_{\Delta t},$$ has the temperature effects included.

$$\left(\frac{B}{A}\right)_{\Delta t} = \left(\frac{B}{A}\right)\left(\frac{\sigma_d \Delta t + 1}{\sigma_c \Delta t + 1}\right)$$

Combining the two parts in the equation for the capacitance above provides a basic expression for value of the coupling capacitor, when exposed to the desired temperature variation:

$$C_{\Delta t} = \frac{2\pi\epsilon_0\epsilon_r}{\ln\left(\dfrac{B}{A}\dfrac{\sigma_d \Delta t + 1}{\sigma_c \Delta t + 1}\right)} L(\sigma_s \Delta t + 1)$$

From this, a variation in capacitance over the same $\pm25°C$ degree temperature variation around the average, 50°C in total, compared to the capacitance without temperature compensation, for a typical medium-voltage cable where A=18mm and B=28 mm and a sensor element length of 5 cm, of 0.95%.

This variation is over a temperature range of $\pm25°C$ is thus $\pm1\%$ and is acceptable for many applications. However, a number of inexpensive techniques can significantly improve the obtainable precision as described below.

The semiconducting layer has a high conductivity. Typically a value of 1 k$\Omega$cm$^{-1}$ or less is obtained for a modern cable. The layer is also extremely temperature-dependent and may have a linear or non-linear dependence on the cable voltage in some cases, making it a significant unknown in the sensor construction.

As this layer is effectively left unperturbed, as much as possible, to guarantee the continuity of the electric field inside the cable, and building the coupling capacitor electrode on top of it, the layer, which is connected to the cable shield, and thus ground, essentially presents a short to the 212M$\Omega$ impedance of the coupling capacitor for the grid fundamental. This, in itself, would not be a problem if the resistance of the semiconducting layer is well-defined and stable. It would then simply be part of the voltage divider needed in the sensor.

In accordance with the present invention, a capacitor is constructed on a cable using the dielectric of the cable itself. This capacitor is combined with a second impedance to ground, typically the electrostatic shield or cable shield, to obtain a voltage divider. The second impedance, preferably a capacitor, may be chosen to match the temperature dependence of the coupling capacitor to correct for its thermal dependence. This requires a thermal link between these capacitances and the coupling capacitor. Other methods may use a measurement of the sensor temperature and correct the thermal errors indirectly.

In Figure 1, a first embodiment of the construction of a sensor arrangement 100 in accordance with the present invention is shown. The sensor arrangement 100 is shown where a sensor 150 is located on a high-voltage cable 110. The cable 110 comprises a central cable conductor 114 that is covered by dielectric layer 116. Over the dielectric layer 116 is a semiconducting layer 118. Here, the semiconducting layer 118 is stripped back and replaced by a different semiconductor layer 120 that comprises a non-linear resistive material whose resistivity changes with the voltage passing through the cable 110. The sensor 150 comprises a sensing electrode 152 positioned on the semiconducting layer 120, and a pair of guard electrodes 154, 156.

A further dielectric layer 158 and an electrostatic shield 160 are applied in turn over the electrodes 152, 154, 156. The electrostatic shield is connected to a cable shield (not shown) by way of an electrical connection (also not shown). As shown, the guard electrodes 154, 156 are located on either side of the sensing electrode 152 and they are connected to one another by means of an isolated electrical connection (not shown). The isolated electrical connection may also be shielded by the electrostatic shield 160.

It will be appreciated that the electrostatic shield 160 may comprise a continuation of the cable shield and in that case, the electrical connection to the cable shield is not needed.

Optional conductor electrodes 166, 168 may also be provided adjacent each of the guard electrodes 154, 156. In this case, the conductor electrodes 166, 168 are located on respective sides of the guard electrodes 154, 156 that are remote from the sensing electrode 152. These electrodes 166, 168 are used to improve the definition of the sensing electrode 152 to ground resistance of the electrostatic shield 160. The electrostatic shield may comprise the cable shield that has temporarily been removed to allow the construction of the sensor 150 on the cable 110.

The sensor arrangement 100 may include a tri-axial conductor (not shown) that provides electrical connections to the sensing electrode 152, to the guard electrodes 154, 156, and to the electrostatic shield 160.

It will readily be appreciated that as the cable 110 is cylindrical having a circular cross-section, the electrodes 152, 154, 156, 166 and 168 and the electrostatic shield 160 are preferably implemented as cylinders. However, other shapes can be used but may result in degradation in the performance of the sensor 150.

The further dielectric layer 158 preferably overlaps to some extent with the optional electrodes 166, 168 to ensure that sections of semiconductor layer 120 between those electrodes and the sensing electrode 152 are provided.

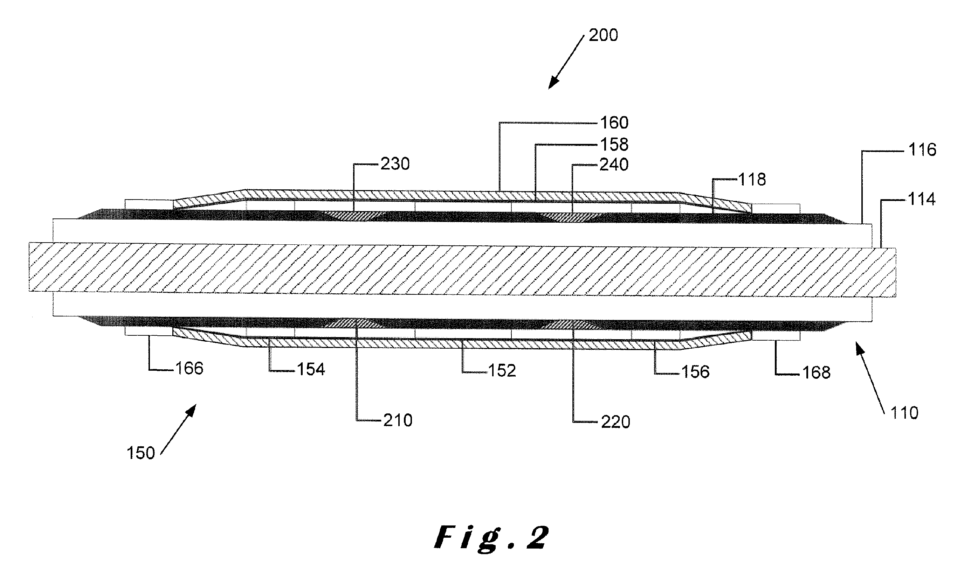

Turning now to Figure 2, a second embodiment of a sensor arrangement 200 in accordance with the present invention is shown. Components previously described with reference to Figure 1 are referenced the same in Figure 2. The cable 110 is as described with reference to Figure 1, but in this case, the semiconducting layer 118 is not stripped back but has isolation grooves 210, 220 formed in it so that portions of the dielectric 116 are exposed. This provides isolation between sensor electrode 152 and guard electrodes 154, 156. As before, a further dielectric layer 158 and an electrostatic shield 160 are formed over the electrodes 152, 154, 156, 166, 168. Additionally, the grooves may be filled with a suitable non-linear field control material 230, 240 to improve the electric field gradients at these locations.

Electrical connections are made as described with reference to Figure 1. The electrostatic shield may comprise the cable shield as described above.

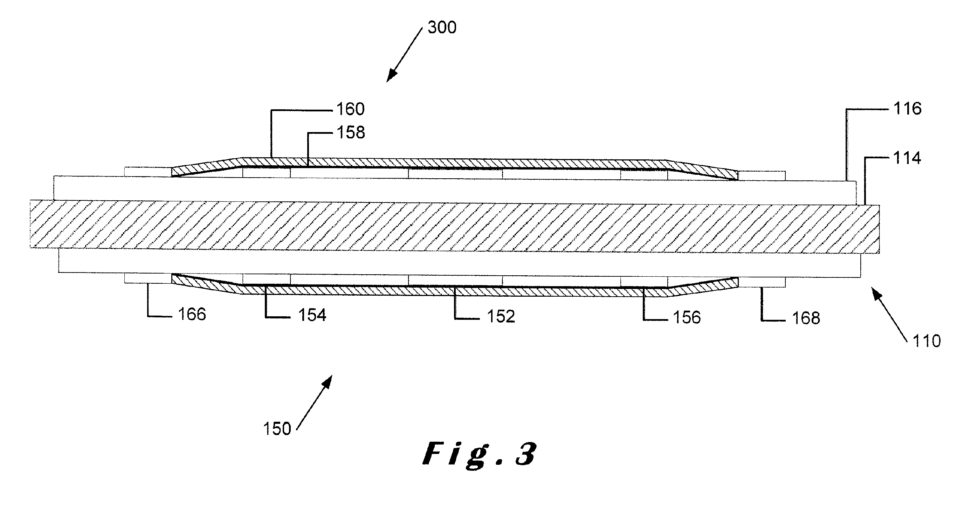

In Figure 3, a third embodiment of a sensor arrangement 300 in accordance with the present invention is shown. Components that have been described above with reference to Figure 1 are referenced the same in Figure 3. Here, the semiconducting layer has been removed to expose the dielectric layer 116. This embodiment also applies to those cables that do not incorporate a semiconducting layer. The sensor electrode 152 and guard electrodes 154, 156 are constructed directly onto the exposed surface of the dielectric layer 116. Similarly, the additional electrodes 166, 168 are also constructed on the dielectric layer 118. A further dielectric layer 158 and an electrostatic shield 160 provided over the electrodes 152, 154, 156, 166, 168 as described above. The electrostatic shield may comprise the cable shield as described above.

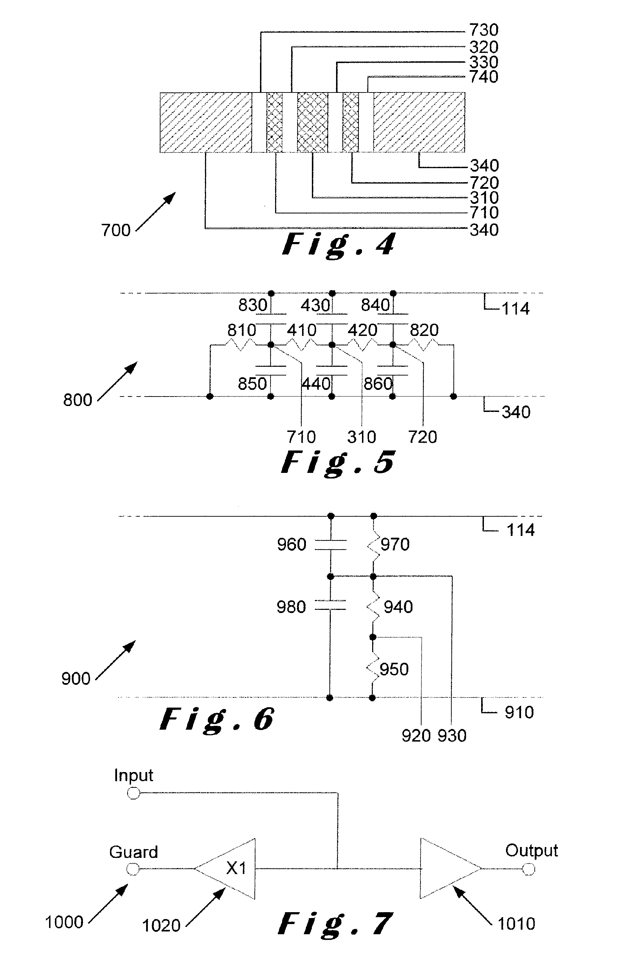

Figure 4 illustrates a sensor electrode arrangement 700 that comprises a sensing electrode 310 located between two exposed portions 320, 330 of semiconducting cable material as described above with reference to Figures 1 and 2 above. A grounded electrostatic or cable shield 340 is provided around the semiconducting layers 320, 330 remote from the sensing electrode 310 and extends over the whole construction (not shown). Guard electrodes 710, 720 and two further exposed semiconducting sections 730, 740 are also shown. Here, guard electrode 710 is in between exposed semiconducting sections 730 and 320 and guard electrode 720 is in between exposed semiconducting sections 330 and 740.

The connection terminal to the sensing device in the voltage-mode is not held at ground potential, allowing parasitic currents to flow through the parasitic components resulting in parasitic voltages which mar the voltage measurement. The guard electrodes 710, 720, when driven by the signal processing circuit, as described below, to the same potential as the sensing electrode 310, will prevent a potential difference between the sensing electrode 310 and the guard electrodes 719, 720.

Figure 5 illustrates an equivalent circuit 800 of the sensor electrode arrangement 700 shown in Figure 4. Resistors 410, 420 represent respective sections of semiconducting layer 320, 330 between the sensing electrode 310 and the guard electrodes 710, 720. Resistors 810, 820 represent the other two exposed portions 730, 740 of the semiconducting layers, with resistor 810 being connected between the cable shield 340 and guard electrode 710 and resistor 820 being connected between the cable shield 340 and guard electrode 720. Capacitors 830, 840 represent parasitic capacitances between the central conductor 114 and respective ones of the guard electrodes 710, 720. Capacitors 850, 860 represent parasitic capacitances between the guard electrodes 710, 720 and the cable shield 340.

Figure 6 is a simplified version 900 of Figure 5 for use with a voltage-mode signal conditioning unit with guard electrodes. The central conductor 114 of the cable 110 and a grounded cable shield 910 is shown. The objective of the signal conditioning is to accurately mirror, on connection 920, the voltage on connection 930, which represents the sensor output. When this condition is satisfied, the parasitic resistances due to the semiconducting layer or due to contamination, as represented by resistors 940, 950, are negated and a voltage divider comprising capacitors 960, 980 and resistor 970 remains. Capacitor 960 represents the sensing capacitance between the conductor 114 of the cable 110 and the sensing electrode 310 and capacitor 980 represents the capacitance between the sensing electrode 310 and the cable shield 340. Resistor 970 represents the conductivity due to the dielectric 116 of the cable 110 (Figures 1 to 3). Resistors 940, 950 represent conductivity due to the portions 320, 330, 730, 740 of semiconducting layer and/or contamination. Resistor 970 represents the conductivity of the dielectric 116 of the cable 110 and can generally be ignored.

The parasitic components could, however, also be taken out of the system response if the potential on connection 920 were to be kept identical to that on connection 930 corresponding to the output from the sensor. If that is the case, no current flows through resistor 940 as there is no potential difference across it. Thus, the influence of the parasitic conductivity of the semiconducting layer represented by resistors 940, 950 is removed from the system response at connection 930. Forcing of an equi-potential in a section of a circuit to reduce the influence of parasitic elements is known as guarding. Although capacitor 980 is still present, its influence can easily be swamped by a known, stable capacitor of much larger magnitude. The latter is, in practice, the case, as will be shown in the examples section. If this capacitor is well-chosen and thermally-linked with the coupling capacitor, automatic thermal correction of the division ratio is also readily obtained.

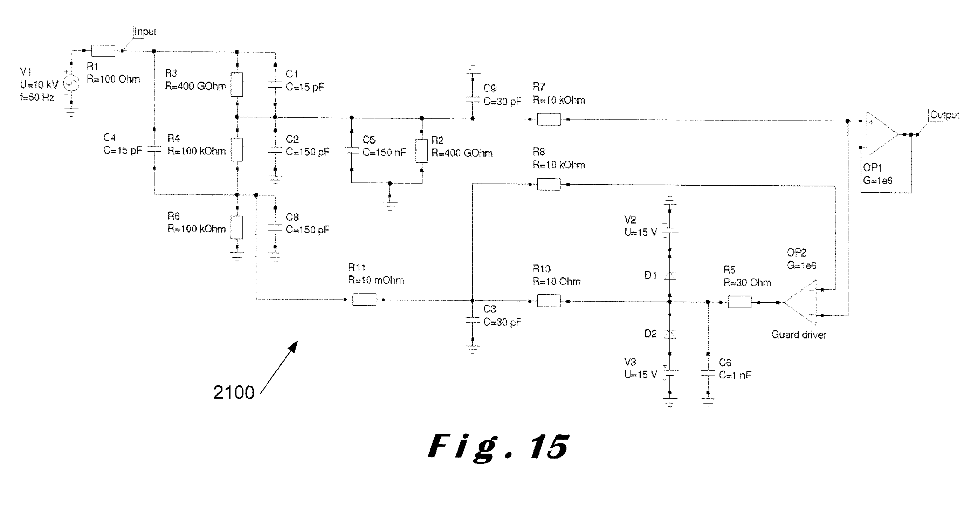

A circuit that can drive the sensor and accomplish guarding is shown in Figure 7 with a basic implementation being shown in and described with reference to Figure 15 below.

Figure 7 illustrates a voltage-mode signal conditioning unit 1000 for a sensor having guard electrodes. A gain stage 1010 is used to obtain a buffered output. A gain buffer 1020 is used to obtain a buffered output, and comprises a highly accurate unity gain buffer, preferably compensated for wiring and protection induced errors, which applies an accurate mirror of the sensor output to the guard electrodes. The mirroring of the output voltage on the gain electrodes must be as precise as possible to maintain the assumption that there is no current through the parasitic resistances and therefore their cancellation from the overall sensor response. Furthermore, the loading placed by the circuit on the sensor output must be a small as possible. Therefore, the circuit must maintain very high input impedance for accuracy. Additionally, the accuracy of amplifier 1020 is of paramount importance for the guarding to be truly effective.

Temperature compensation can also be readily added to the sensor, as the dependencies on temperature, through the use of guarding, are reduced due to the change in capacitance of the coupling capacitor. More significantly, and much harder to accurately and generally correct for, changes in the parasitic components are effectively removed from the sensor response.

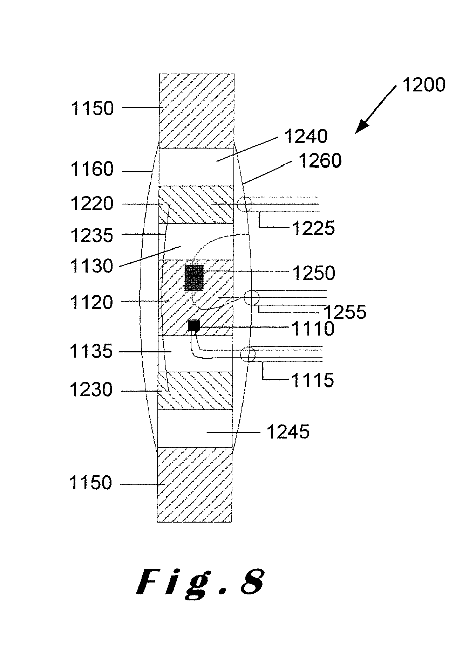

Temperature compensation can be accomplished in many ways. However, two eminently practical methods may be readily used with the sensor, shown in Figure 8 for voltage-mode operation. First, one could simply measure the temperature of the device and, since most parasitic components but the actual sensor itself are compensated for, one would only need to correct the reading in the signal processing from the temperature measurement. A second more elegant and economical method is to place a thermally variable component of the signal processing circuit in the sensor so it may share the structural temperature of the sensor and a correction can be achieved.

The voltage division capacitor and the measurement capacitor may be chosen so that the thermal variability of the measurement capacitor closely matches that of the coupling capacitor constructed on the cable. In this way, the sensor division ratio can be maintained constant. A suitable thermal behaviour may readily be obtained by combining several commercially available capacitor types to synthesise the desired response. Good results may be obtained as the thermally-induced sensor capacitor deviations are in the same general range as practical inexpensive film capacitors.

In Figure 8, a sensor arrangement 1200 is shown that has two temperature compensation schemes for voltage-mode operation. The two compensation schemes comprise a temperature sensor and an integrating capacitor which may be used together or separately.

In Figure 8, a temperature sensor 1210 is provided, the output of which can be used in signal processing to correct for temperature-related errors. A sensor coupling capacitor electrode 1120 is shown between a grounded shield 1150. This shield is continued through the electrostatic shield 1160 which covers the sensor and connects the two portions of the grounded shield 1150. A temperature sensor 1110 is located on the sensor coupling capacitor electrode 1120. In the sensor arrangement 1200, guard electrodes 1220, 1230 are provided on either side of the sensor coupling capacitor electrode 1120 and between exposed regions 1130, 1135 and additional exposed regions 1240, 1245 of a semiconducting layer as shown. Connection 1235 links the two guard electrodes 1220, 1230 so that they are at the same potential.

The sensor arrangement 1200 also includes a measurement capacitor 1250 that is used to complete a voltage divider with the coupling capacitor electrode 1120. By thermally joining the measurement capacitor 1250 with the electrode 1120, and making a careful choice in its type, temperature-related errors may be corrected. In practice, either or both of the temperature sensor 1110 and the measurement capacitor 1250 may be used.

A shielded connection 1255 is provided to the capacitor 1250 and a shielded connection 1115 is provided to the temperature sensor 1110. The shielded connection 1225 is also electrically connected to the measurement capacitor 1250 when it is present in the sensor arrangement 1200. The other end of the measurement capacitor 1250 is connected to ground as shown by connection 1260. A shielded connection 1225 is also provided to the guard electrode 1220 which in turn is electrically connected to the other guard electrode 1230 by connection 1235. Connection 1260 also connects the shielded connections 1115, 1225, 1255 to ground via the grounded shields 1150. An applied shield 1160 is utilised.

In practice, all three shielded connections 1115, 1225, 1255 may be joined in a single, shielded cable assembly, for example, a tri-axial cable or a co-axial cable if only one of the temperature sensor or measurement capacitor is provided, in which each of these electrical connections is shielded from the others. However, it will be appreciated that in Figure 8, these shielded connections are shown separately for clarity and for ease of explanation.

In relation to temperature compensation, an advantage of using the semiconducting layer, beyond electric field gradient control, is that, in a practical cable, the semiconducting layer is typically moulded to the dielectric layer, resulting in a close mechanical union. By building on top of this, the sensor geometry is better defined and more easily follows the cable thermal expansion and contraction. Furthermore, if the metallic electrode used to build the coupling capacitor has non-uniformities in its application, the semiconducting layer with which it is in contact will ensure that the effective capacitor cylinder is in fact that section of the semiconducting layer with which the copper is in contact, and is thus always smooth and perfectly attached to the dielectric layer. This reduces the requirements on the build-up of the sensor.

The use of a corrugated, coiled, or otherwise spring-like electrode could be implemented to ease installation and to give the whole a better capacity to stay in contact with the cable. The semiconducting layer under the construction serves as the functional capacitor cylinder conductor, while the corrugated electrode serves to keep in close electric contact with the layer and still allow enough flexibility to follow expansion/contraction. This is possible, as the conductivity of the semiconducting layer is high compared to the impedance of the coupling capacitor, and the added resistivity due to the short sections of the semiconducting layer can be considered to be negligible.

The main issues encountered with the capacitive coupling build on top of the semiconducting layer are those, as described above, of the very high impedance offered by the coupling capacitor for the grid fundamental and the highly variable impedance of the semiconducting layer to ground.

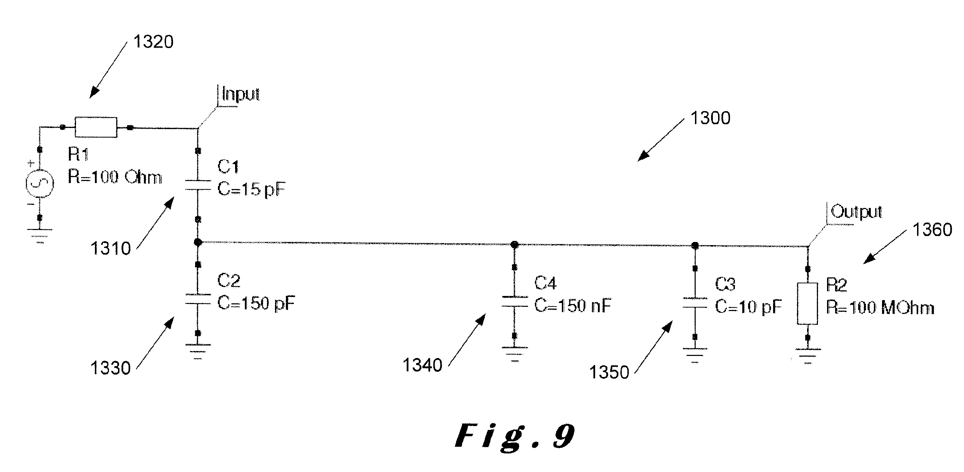

In Figure 9, the basic configuration for a capacitive voltage divider is shown to illustrate the detrimental effect of the semiconducting layer (or contamination) on the sensor if no compensation techniques are employed. An idealised model for a voltage sensor circuit 1300 having a coupling capacitor 1310 having a capacitance of 15pF, the capacitor 1310 receiving an input from a voltage supply 1320 operating at 10kV and 50Hz is shown. Parasitic capacitance from the coupling capacitor 1310 to the cable shield is represented by capacitance 1330 and this is typically 150pF. A loading capacitor 1340 is used to set the voltage division ratio, and capacitor 1350 and resistor 1360 represent a fair approximation of the input properties of a signal conditioning circuit (not shown). The loading capacitor 1340 may have a capacitance of 150nF, capacitor 1350 a capacitance of 10pF and the resistor 1360 a resistance of 100MΩ.

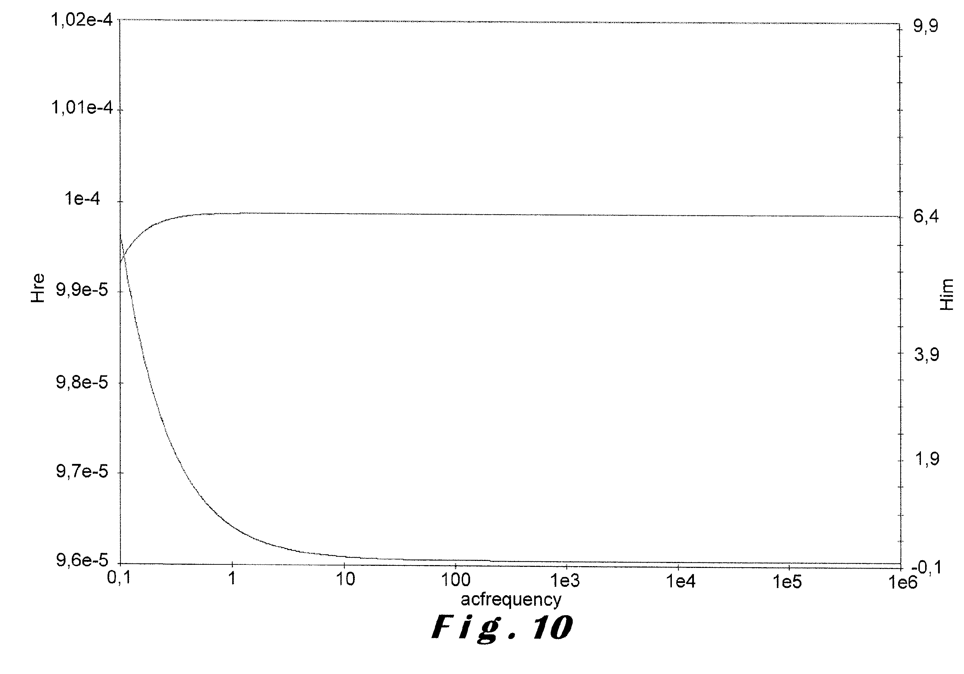

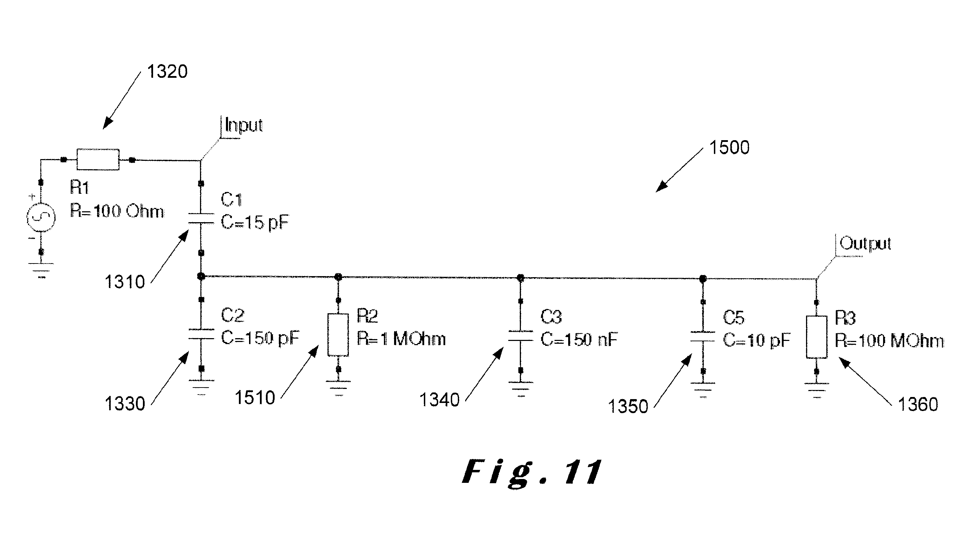

Figure 10 shows the frequency response of the circuit of Figure 9. Here, the X-axis is in Hz, the left Y-axis is the ratio $V_{out}/V_{in}$, and the right Y-axis is in degrees. The performance is very good over a very wide frequency range. The configuration relates closely to the arrangement described in DE-A-3702735 discussed above. Starting from this point, the issues of sensor contamination and the use of the semiconducting layer are described with reference to Figures 11 to 14.

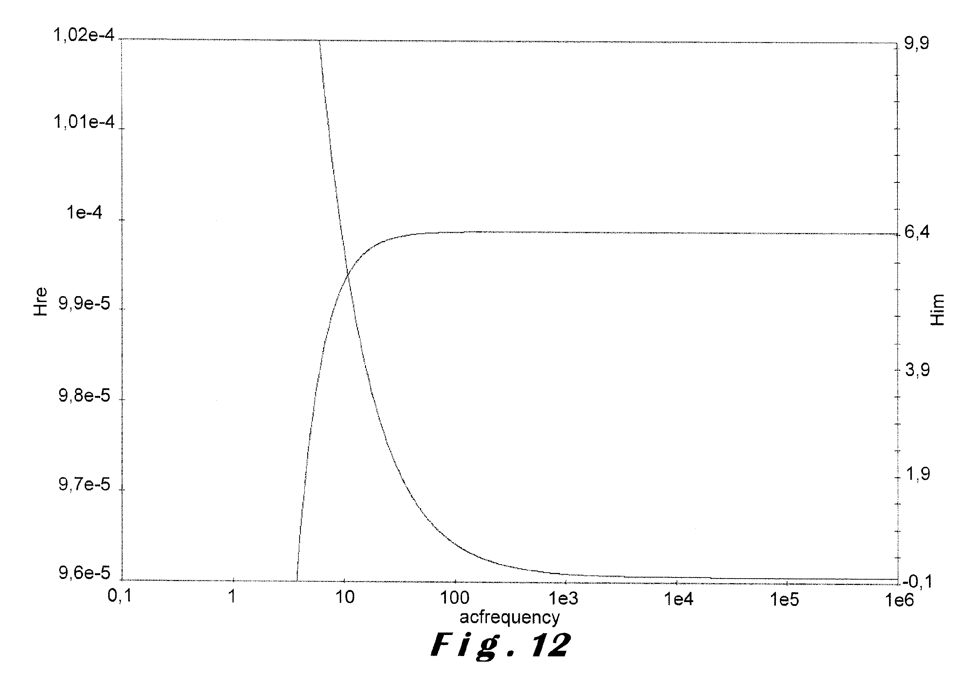

Figure 11 illustrates a voltage sensor circuit 1500 that is identical to Figure 9 apart from the addition of some contamination. This contamination is represented by resistor 1510 and has a value of 1MΩ. This value can easily be obtained due to the presence of a small amount of moisture in the structure. The resulting degraded frequency response is shown in Figure 12. The axes are labelled the same as in Figure 10 and have the same scale.

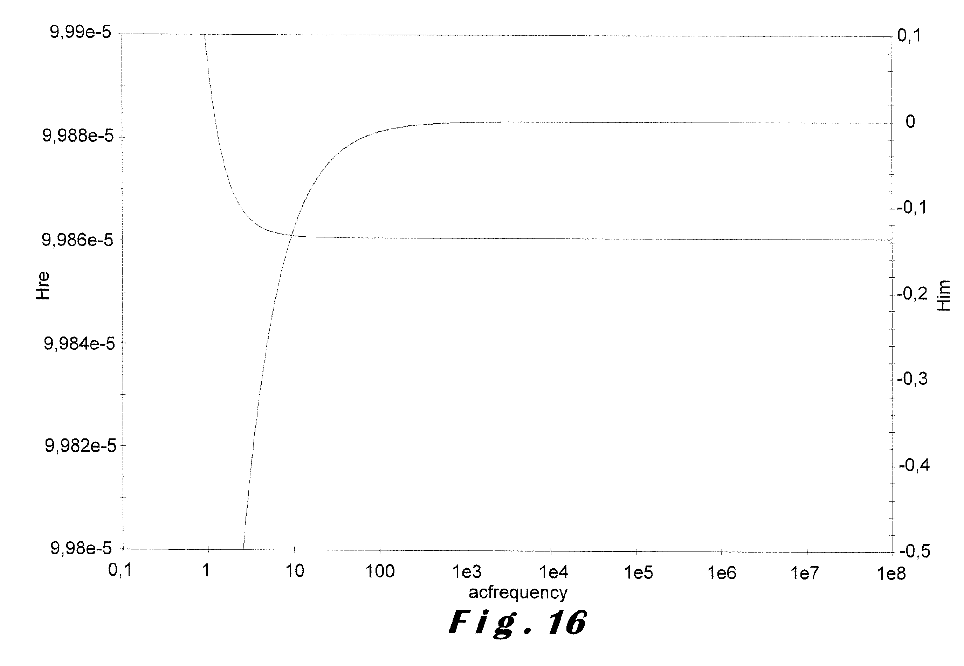

Compensation for contamination is difficult as the contamination is usually unknown and can be time-variant. As shown in Figure 16, it can readily be seen that even slight contamination ruins the sensor precision.

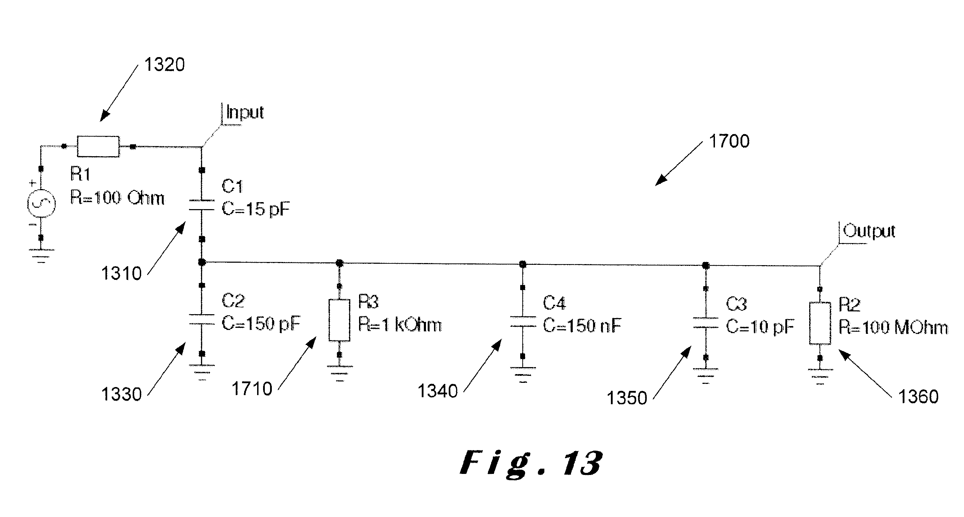

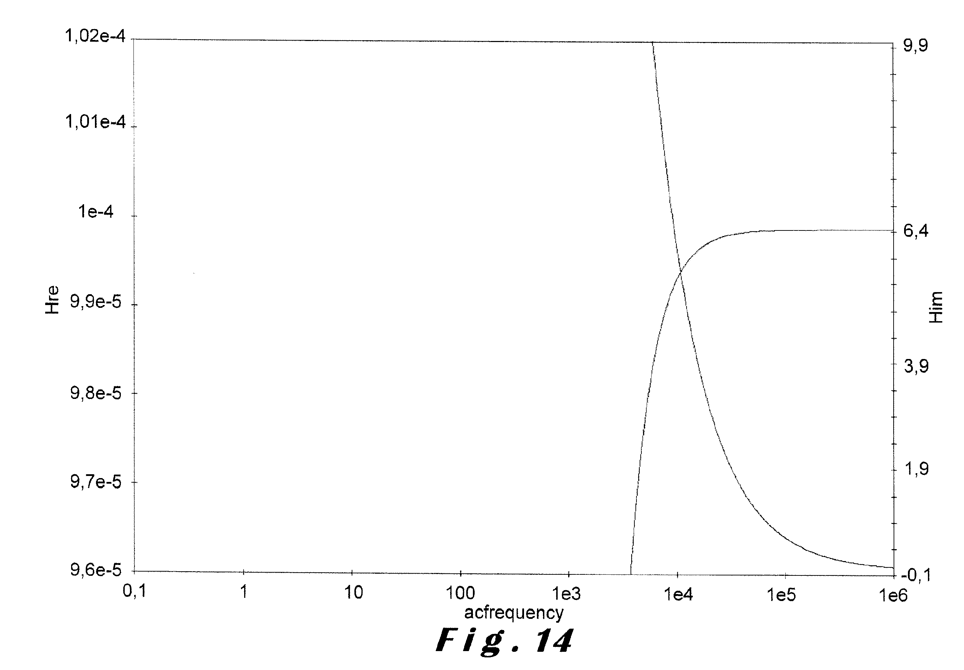

Additionally, the effects of the semiconducting layer are shown in Figure 13. Figure 13 illustrates a voltage sensor circuit 1700 that is identical to that of Figure 13 but with resistor 1710 representing the effects of the semiconducting layer. Resistor 1710 typically has a value of 1kΩ. The layer may be thought of as an extreme case of contamination. Here, a severely degraded sensor response is obtained as shown in Figure 14. The axes are labelled the same as in Figure 10 and have the same scale. As before, due to the large variability of the semiconducting layer conductivity with temperature, as well as the possibility for additional contamination, both thus being time-variant, and therefore compensation can be difficult.

For ease of comparison, the scales used in Figures 10, 12 and 14 are the same. However, the scales used for subsequent Figures may differ.

When the guarding technique is used, significant improvements in sensor performance can be obtained as described with reference to and illustrated in Figures 15 and 16. In each case, the semiconducting layer is used.

In Figure 15, an idealised voltage-mode implementation of a sensor circuit 2100 with a signal conditioning circuit is shown. Here, guarding is provided. The salient sensor parasitic impedances are included, together with those for the guard electrodes, circuit wiring and basic protection devices. A unity-gain buffer, with high open-loop gain over a wide frequency range, OP2 is used to drive the guard electrodes and a buffer amplifier OP1 is used to isolate the load of external circuitry from the sensor. A loading capacitor C5 is shown that comprises the capacitor C5 and a parasitic resistor R2. Capacitor C1, with the parasitic resistor R3, represents the coupling capacitor. Capacitor C2 and C8 are parasitic capacitors from the electrodes to the shield. Capacitor C4 is a parasitic coupling between the cable conductor and the guard electrodes. Resistors R4 and R6 represent the exposed sections of cable between the guard electrodes and the sensing electrode and between the guard electrodes and ground respectively. These may be sections of semiconducting layer, bare cable dielectric with contamination, or other materials with a given conductivity.

Input signal V1 is the same as that shown in Figures 9, 11, and 13 above and comprises the voltage that is to be measured. C3 and C9 represent the parasitic capacitances of the wiring joining the sensor with the signal processing circuit.

R11 represents the wire resistance. In this part of the circuit, this has a significant effect on the accuracy of the guarding performance, as any voltage drop over this resistor diminishes the precision of the guarding system significantly. R7, R8, and R10 represent protection resistors that limit the current flowing into the signal processing circuit in the case of an over-voltage condition. R5 represents the output resistance of OP2. C6 is present to slow-down the voltage rise gradient in case of an over-voltage condition, leaving the protection diodes D1 and D2 enough time to start conducting. V2 and V3 represent the circuit power supply.

Figure 16 shows the simulated results with the axes labelled the same as in Figure 14 but the scales are different on both Y-axes. Again, a significantly improved response is obtained in sensor response.

As described above with reference to Figures 15 to 16, the voltage-mode with explicit guarding allows the sensor to achieve usable performance in the presence of contamination, non-linear or regular semi-conducting materials, or other influences that would otherwise load the capacitive divider in undesired and unpredictable ways. It has to be noted that the minimal resistance between the sensor electrodes usable in practice will be limited to several tens of kΩ. This because of practical accuracy limits that can be obtained with the guarding circuit. If this condition is satisfied, a practical sensor with stable performance, comparable to that of a construction with a clean, bare dielectric is possible.

As described above with reference to Figures 15 to 16, voltage-mode with explicit guarding allow the use of the semiconducting layer in a practical sensor that have comparable performance.

Prototype sensors were constructed to validate the use of such sensors in practice.

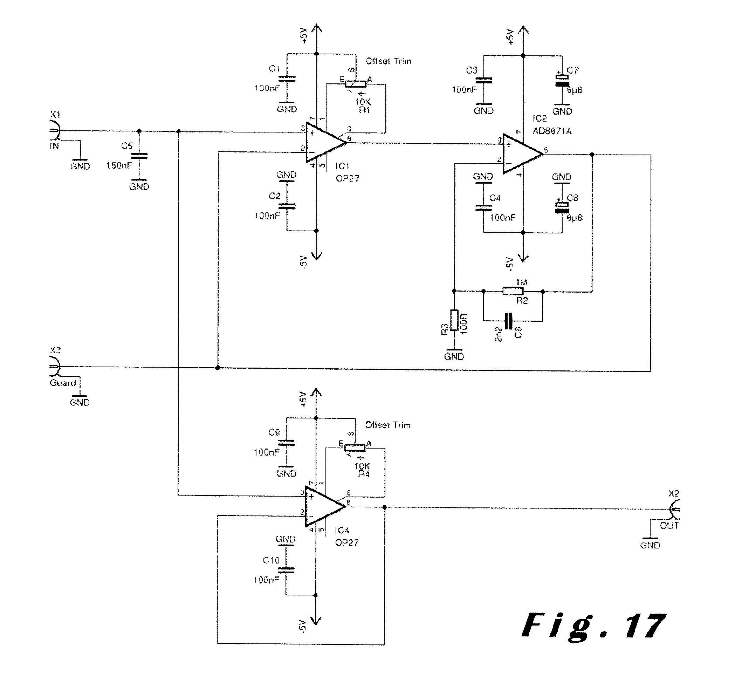

Figure 17 illustrates a signal conditioning unit required for a voltage-mode sensor. It implements a measurement amplifier, configured as a unity-gain buffer which, combined with the voltage divider formed by the sensor coupling capacitance and a second measuring capacitor, yields a scaled measurement of the voltage on the cable. Furthermore, a composite, high-precision unity-gain buffer is implemented to drive the guard electrodes.

For the guarding effect that compensates for the sensor parasitic elements to be effective, voltage divider should not be loaded significantly by the circuit. The voltage on the sensor capacitor constructed on the cable should be mirrored as precisely as possible on the guard electrodes surrounding this sensor capacitor.

If the potential on the sensor capacitor and guard electrodes is identical, then no current can flow between them, effectively removing the parasitic loading on the voltage divider composed of the sensor capacitor and the measuring capacitor due to undesired conductivity of the (non-linear) semiconducting layer and/or contamination of the dielectric between the sensor elements and other cable structures, which may be at a different potential, such as ground.

In practice, the embodiment described below achieves this guard condition by means of a guard driver based on an composite amplifier. For the conditions described above to hold true, a high open-loop gain of at least $10^6$ or more is required over the frequency range of interest. This requirement is generally not feasible with commercially available operational amplifiers which are the building blocks of choice for such a circuit. Their DC gain, indeed, easily exceeds the required gain, but it quickly rolls-off to become insufficient for the power system fundamental frequency and beyond. A solution is presented in the form of a composite amplifier where two operational amplifiers combine gain, accuracy, and drive capability to result in a gain stage with sufficient open-loop gain to implement a sufficiently precise unity-gain buffer to serve as the guard driver for the present application.

In the circuit of Figure 17, the precision, unity-gain stage is composed of operational amplifiers IC1 and IC2, while IC4 implements the measuring buffer that isolates the voltage divider from loading and other disturbances from external wiring and connecting circuitry. In this circuit, the latter is set for unity gain, but any other factor may be chosen to correct the overall sensor voltage division ratio to the desired value. The basic ratio is that set by the voltage divider composed out of the capacitor of the sensor and C5, the measuring capacitor. The latter should, ideally, be installed as close as possible to the sensor, preferably integrated with the physical construction, to minimise wiring parasitic capacitance effects and improve thermal tracking, in case the measuring capacitance thermal behaviour is selected to match that of the sensor capacitor.

In order to obtain the required high AC gain for the guard circuit, exceeding 120dB for the frequencies of interest, a composite amplifier is build using IC1 and IC2. The parts were chosen to obtain good DC accuracy, low drift, low noise, and high gain. Stability is maintained by rolling-off the gain for IC2, set to provide 80dB at low frequencies by R2 and R3, through the C6 bypass.

Capacitors C1, C2, C3, C4, C7, C8, C9, and C10 are power supply bypass capacitors for the operational amplifiers. R1 and R4, finally, are the offset null adjustment for the composite and buffer amplifiers. These may not be required in many applications.

Although the present invention has been described with reference to the use of the semiconductor layer and guard electrodes (Figures 1 and 2), it will be appreciated that the presence of the semiconducting layer is optional as described with reference to Figure 3. However, significant advantages may be obtained through the combined use of the semiconducting layer and the guard electrodes. Specifically, in practice, using the semiconducting layer requires guarding techniques, while guarding by itself can improve a sensor build that does not require use of the semiconducting layer and significantly reduces its sensitivity to external factors, such as contamination.

It will be appreciated that, although voltage measurements can be achieved using the particular sensor arrangements describe above, other sensor arrangements can be implemented that utilise the structure of the electrical cable whose voltage is to be measured.

## Claims

1. Measurement apparatus for measuring the voltage of an insulated electrical cable including at least one central conductor and at least a dielectric layer formed over the central conductor(s), the apparatus comprising:

   an electrode element arranged around the cable; and
   an electrical circuit connected to the electrode element and said at least one central conductor; **characterised in that** the electrode element and the insulated electrical cable together form a sensing capacitor that is connected to the electrical circuit, the sensing capacitor has a dielectric that comprises at least the dielectric layer and the semiconductor layer of the insulated electrical cable;
   and **in that** the measurement apparatus further comprises first and second guard electrode elements arranged on either side of the electrode element and spaced to be equi-distant from therefrom.

2. Measurement apparatus according to claim 1, wherein the first and second guard electrode elements are electrically connected to one another and are at the same potential.

3. Measurement apparatus according to claim 2, wherein the first and second guard electrode elements are at the same potential as the electrode element.

4. Measurement apparatus according to any one of the preceding claims, wherein the electrode elements are constructed on the dielectric layer.

5. Measurement apparatus according to any one of claims 1 to 3, wherein the electrical cable includes a semiconducting layer formed over the dielectric layer, and wherein the electrode elements are constructed on the semiconducting layer.

6. Measurement apparatus according to claim 5, wherein the semiconducting layer has grooves formed through to the underlying dielectric layer between the electrode element and respective ones of the first and second guard electrode elements.

7. Measurement apparatus according to claim 6, wherein the grooves are filled with another type of semiconducting layer.

8. Measurement apparatus according to any one of claims 5 to 7, wherein the semiconducting layer comprises a non-linear resistive material.

9. Measurement apparatus according to any one of the preceding claims, further comprising first and second additional electrode elements positioned either side of the electrode element, each additional electrode element being located adjacent a respective one of the first and second guard electrode elements and on a side remote from the electrode element.

10. Measurement apparatus according to any one of the preceding claims, further comprising a further dielectric layer placed over at least the electrode element.

11. Measurement apparatus according to claim 10, further comprising an electrostatic shield placed over the further dielectric layer.

12. Measurement apparatus according to claim 11, wherein the electrostatic shield is connected to a shield on the insulated electrical cable.

13. Measurement apparatus according to claim 11, wherein the electrostatic shield comprises a shield formed on the insulated electrical cable.

14. Measurement apparatus according to any one of the preceding claims, wherein the electrical circuit comprises a voltage-mode signal conditioning circuit.

**15.** Measurement apparatus according to any one of the preceding claims, further comprising a measurement capacitor associated with the electrode element.

**16.** Measurement apparatus according to any one of the preceding claims, further comprising a temperature sensor associated with the electrode element.

*Fig. 1*

Fig. 2

*Fig. 3*

730
320
330
740

340
720
310
710
340

700

*Fig. 4*

830  430  840
114
810  410  420  820
850  440  860
800
340

710  310  720

*Fig. 5*

114
960  970
980  940
900
950
910
*Fig. 6*
920 930

Input

Guard                                    Output
X1
1000      1020      *Fig. 7*      1010

1150

1160

1220

1235

1130

1120

1135

1230

1150

1200

1240

1260

1225

1250

1255

1110

1115

1245

# Fig. 8

*Fig. 9*

*Fig. 10*

*Fig. 11*

*Fig. 12*

EP 2 508 898 A1

*Fig. 13*

Fig. 14

*Fig. 15*

*F i g . 16*

27

Fig. 17

Offset Trim

C1
100nF
GND

+5V

E  S  A
10K
R1

X1
IN
GND

C5
150nF
GND

IC1
OP27

GND
C2
100nF

-5V

C3
100nF
GND

+5V

C7
6µ6
GND

IC2
AD8671A

GND
C4
100nF

GND
C8
6µ8

-5V

1M
R2

R3
100R

2n2
C6

GND

X3
Guard
GND

Offset Trim

C9
100nF
GND

+5V

E  S  A
10K
R4

IC4
OP27

GND
C10
100nF

-5V

X2
OUT
GND

Europäisches
Patentamt

European
Patent Office

Office européen
des brevets

# EUROPEAN SEARCH REPORT

Application Number

EP 11 16 1709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 37 02 735 A1 (TROTT JOSEF DIPL ING [DE]) 11 August 1988 (1988-08-11) | 1-5, 10-15 | INV.<br>G01R15/06 |
| Y | * the whole document * | 9,16 | |
| X | US 5 051 733 A (NEUHOUSER DONALD [US]) 24 September 1991 (1991-09-24)<br>* the whole document * | 1 | |
| A | DE 195 15 068 A1 (LEMKE EBERHARD PROF DR ING HAB [DE]; SCHMIEGEL PETER DR ING [DE]) 31 October 1996 (1996-10-31)<br>* abstract; figure 1 * | 1 | |
| A | DATABASE WPI<br>Week 201074<br>Thomson Scientific, London, GB;<br>AN 2010-L55190<br>XP002662542,<br>-& KR 2010 0094748 A (LG CABLE LTD) 27 August 2010 (2010-08-27)<br>* abstract * | 1 | |
| A | US 2005/218905 A1 (PRUNK HARRY [DE] ET AL) 6 October 2005 (2005-10-06)<br>* abstract * | 1 | TECHNICAL FIELDS SEARCHED (IPC)<br>G01R |
| Y | US 4 241 373 A (LECOURT WILLIAM N [US] ET AL) 23 December 1980 (1980-12-23)<br>* column 7, line 66 - column 8, line 4; figure 5 * | 16 | |
| Y | JP 58 174856 A (YOKOGAWA ELECTRIC WORKS LTD) 13 October 1983 (1983-10-13) | 9 | |
| A | * abstract; figures 1-4 * | 1-5,14 | |

-/--

The present search report has been drawn up for all claims

| Place of search | Date of completion of the search | Examiner |
|---|---|---|
| Berlin | 1 November 2011 | Koll, Hermann |

EPO FORM 1503 03.82 (P04C01)

Europäisches
Patentamt

European
Patent Office

Office européen
des brevets

## EUROPEAN SEARCH REPORT

Application Number

EP 11 16 1709

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 963 819 A (CLARKE GRAHAM J [GB] ET AL) 16 October 1990 (1990-10-16)<br>* abstract; figures 2, 5 *<br>* column 8, line 56 - column 11, line 17 *<br>* column 12, line 25 - line 53 *<br>----- | 1-3 | |

TECHNICAL FIELDS
SEARCHED      (IPC)

The present search report has been drawn up for all claims

| Place of search | Date of completion of the search | Examiner |
|---|---|---|
| Berlin | 1 November 2011 | Koll, Hermann |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 11 16 1709

This annex lists the patent family members relating to the patent documents cited in the above-mentioned European search report.
The members are as contained in the European Patent Office EDP file on
The European Patent Office is in no way liable for these particulars which are merely given for the purpose of information.

01-11-2011

| Patent document cited in search report | | Publication date | Patent family member(s) | Publication date |
|---|---|---|---|---|
| DE 3702735 | A1 | 11-08-1988 | NONE | |
| US 5051733 | A | 24-09-1991 | NONE | |
| DE 19515068 | A1 | 31-10-1996 | NONE | |
| KR 20100094748 | A | 27-08-2010 | NONE | |
| US 2005218905 | A1 | 06-10-2005 | CH 698364 B1 | 31-07-2009 |
| | | | CN 1674164 A | 28-09-2005 |
| | | | DE 102004013606 A1 | 13-10-2005 |
| | | | GB 2412445 A | 28-09-2005 |
| US 4241373 | A | 23-12-1980 | NONE | |
| JP 58174856 | A | 13-10-1983 | NONE | |
| US 4963819 | A | 16-10-1990 | AR 241289 A1 | 30-04-1992 |
| | | | AU 592533 B2 | 18-01-1990 |
| | | | AU 4451585 A | 09-01-1986 |
| | | | BR 8503156 A | 25-03-1986 |
| | | | CA 1277371 C | 04-12-1990 |
| | | | DE 3574777 D1 | 18-01-1990 |
| | | | DK 298285 A | 03-01-1986 |
| | | | EP 0172634 A1 | 26-02-1986 |
| | | | FI 852600 A | 03-01-1986 |
| | | | NO 852639 A | 03-01-1986 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 3702735 A